# EUROPÄISCHE PATENTANMELDUNG

(11) **EP 0 605 786 A1**
(43) Veröffentlichungstag der Anmeldung: **13.07.1994**
(21) Anmeldenummer: 93118969.0
(22) Anmeldetag: 25.11.1993
(51) Int. Cl.: G06F 11/10

(54) **Verfahren und Einrichtung zur fehlercodierenden Datenübertragung**

(30) Priorität: 02.01.1993 DE 4300025
(71) Anmelder: MACROTEK, GESELLSCHAFT FÜR INTEGRIERTE WISSENS- UND DATENVERARBEITUNG mbH, D-44227 Dortmund (DE)
(72) Erfinder: Marks, Karl Michael, D-58642 Iserlohn (DE); von Staudt, Hans Martin, D-59427 Unna (DE); Rückert, Ulrich, Prof. Dr., D-59494 Soest (DE)

(57) **Zusammenfassung**

Die Erfindung betrifft ein Verfahren und eine Einrichtung zur Erkennung und/oder Korrektur von 1- und mehr-Bit-Fehlern gemäß Oberbegriff der Patentansprüche 1 und 5. Um bei einem Verfahren sowie einer Einrichtung der gattungsgemäßen Art eine Optimierung der Fehlererkennung und Fehlerkorrektur bei gleichzeitiger Minimierung der Kodierungstiefe d.h. der Zahl der nötigen Gatterebenen zu erreichen, wird erfindungsgemäß vorgeschlagen, das Datenwort sowie das Prüfwort in jeweils 4-Bit breite Teilworte aufzuteilen, wobei das Prüfwort aus einer Anzahl von p Prüfbits, und das Datenwort aus einer Anzahl von d Datenbits gebildet ist. Zur Prüfwortgenerierung wird eine d*p Generatormatrix verwendet, bei der jeder Spaltenvektor das Generierungsgewicht Gs=d/4, und jeder Zeilenvektor das Generierungsgewicht Gz=p/4 aufweist, derart daß zeilenweise jedes Datenbit maximal 2 Bit in einem Prüfteilwort beeinflusst.

## Beschreibung

Die Erfindung betrifft ein Verfahren sowie eine Einrichtung zur Erkennung und/oder Korrektur von 1- und mehr-bit-Fehlern in Datenworten, welche über Datensammelleitungen gesendet und in Speicherbausteine hinein- oder aus denselben herausgelesen werden, gemäß Oberbegriff der Patentansprüche 1 und 5

Solche Verfahren sowie Einrichtungen sind auf dem Gebiet der Rechnerarchitektur, speziell im Bereich der Hauptspeicherorganisation zu finden.
Die sich rasch fortentwickelnde Komplexität der Software, sowie der Trend zur Steigerung der Verarbeitungsgeschwindigkeit -sprich Taktfrequenz- stellen immer höhere Anforderungen an die Hardware, also an den Computer als Rechen- und Speichermaschine. Hierbei steht im wesentlichen die funktionale Abstimmung des Prozessors mit dem Speicher im Vordergrund.

Moderne RISC-Prozessoren benötigen, um ihre Leistungsfähigkeit optimal zu nutzen, große Hauptspeicherwortbreiten. Die Speicher werden üblicherweise mit sogenannten DRAMs implementiert. In Verbindung mit den genannten RISC-Prozessoren können dann die üblicherweise langen Zugriffszeiten der DRAMs durch die Anlegung großer Hauptspeicherwortbreiten kompensiert werden.

Die erwartete Zielbreite für die nächste Generation von auf RISC-Prozessoren basierenden Rechnern wird die Hauptspeicherbreite von 128 Bit sein.

Die aus DRAMs aufgebauten Speicher weisen eine bestimmte Fehlerrate für sogenannte Soft-Errors auf. Mit der wachsenden Speichergröße wächst somit insgesamt die Anfälligkeit für Soft-Errors. Um dennoch eine ausreichende Zuverlässigkeit übertragener Daten zu gewährleitsten, werden die Daten, d.h. die Datenworte mit sogenannten Fehlererkennungs. bzw. Korrektur-Codes (EDC/ECC) versehen.
Diese lassen in begrenztem Maße eine Erkennung von verfälschten Speicherstellen sowie in bestimmten Fällen die Korrektur solcher Datenfehler zu. Hinzu kommt jedoch, daß die bereits erwähnte fortlaufende Erhöhung der Taktfrequenz immer leistungsfähigerer Rechner die Zeit die zur Auswertung der Fehlercodes zur Verfügung steht verringert.

Aus der Literatur sind eine Vielzahl von Fehlercodierverfahren bekannt, die sicherlich dem Aspekt der Datensicherheit bei der Ubertragung Rechnung tragen, die jedoch den genannten Aspekt der Reduktion der nicht zum Datenhandling gehörenden Prozessoraktivitäten nicht berücksichtigt.

Dabei ist es bekannt beschreib- und wieder lesbare Digitalspeicher so mit Redundanz, d.h. Prüfworten zu versehen, daß eine Fehlererkennung durch wortweise Paritätsprüfung oder Fehlerkorrektur, z.B. SEC-DED-Code, Single Error Correction, Double Error Detection nach Hamming, ermöglicht wird. Eine solche Fehlererkennung, die lediglich 1-bit-Fehler korrigiert und 2-bit, d.h. Doppelfehler erkennt, ist für den Einsatz bei wortorganisierten Speicherbausteinen, bei denen der Ausfall eines einzigen Speicherchips eine Vielzahl von Fehlern pro abgespeicherter Information verursacht, nicht mehr ausreichend. Das sogenannte Checksum-Verfahren bei dem über alle Worte des Speichers eine spaltenweise Paritätsprüfung durch algebraische Summenbildung erfolgt ist bei den Kodierverfahren bekannter Art grundlegend. Es kommt dabei darauf an wie, d.h. über wieviele Datenwortbits die Quersumme gebildet wird. Die Systematik darin entscheidet über Leistungsfähigkeit und Aufwendigkeit des Verfahrens.

Bei den benannten Verfahren erweist sich als nachteilig, daß sie entweder zu einfach, und damit nicht leistungsfähig genug oder zu aufwendig hinsichtlich der Bearbeitungszeit oder der Speicherung sind.

Aus der DE 37 16554 C2 ist ein Verfahren sowie eine Einrichtung der gattungsgemäßen Art bekannt, mit deren Hilfe beschreib- und lesbare Digitalspeicher mit einem Sollprüfwort gesichert werden, welches mit Hilfe eines vorbestimmten Generatorpolynoms aus dem Speicherinhalt erzeugt wird. Beim Testen wird über das Generatorpolynom ein Istprüfwort vom Speicherinhalt erzeugt, daß mit dem Sollprüfwort verglichen wird. Der bestehende Speicherinhalt wird überschrieben, indem mit einer modulo 2-Operation die neue zu speichernde Information auf den bestehenden Speicherinhalt addiert wird. Das Ergebnis wird mit dem Faktor X^{p} multipliziert, wobei P die Position der betreffenden Speicherinformation innerhalb des Speichers angibt. Vom Ergebnis wird eine Restbildung modulo g (x) durchgeführt, wobei g (x) das genannte Generatorpolynom ist. Das entstehende Resultat wird als Änderungsprüfwort bezeichnet, und mit dem alten Sollprüfwort modulo 2 addiert.
Der Testvorgang im Falle einer Unterbrechung durch eine Speicherschreiboperation in dem Fall, daß der Speicherzugriff in einem vom Testvorgang bereits abgearbeiteten Speicherbereich erfolgt, erfolgt derart, daß das Änderungsprüfwort sowohl auf das Istprüfwort, als auch auf das Sollprüfwort aufaddiert wird. Der Testvorgang soll dann nach der Schreiboperation weitergeführt werden können.

Bei diesem bekannten Verfahren ist zwar gegenüber anderen Verfahren zunächst eine weniger speicheraufzehrende Fehlererkennungs- bzw.- Korrekturkodeermittung gegeben, jedoch ist die Inanspruchnahme des Prozessors für die notwendigen zyklischen Rechenprozesse erheblich größer. Nachteilig ist hierbei daß sich die Optimierung lediglich auf eine Reduktion der für die Prüfworte sonst notwendige Speicherkapazität konzentriert. Die gleichzeitige Verkürzung der Prozessorzeiten, sowie der Effekt daß die Erhöhung der Nutz-Wortbreite unter Umständen zu einer effizienten Ausnutzung bzw. Minimierung der Prüfbits führen kann, bleibt hier vollständig außer acht. Des weiteren besteht bei der operativ komplizierten Arbeitsweise die Gefahr, daß sich die Prüfwortbildung verselbstständigt.

Dies kann letztendlich zu einem Datenverlust auf eine derartige Weise führen, daß die verlorenen Daten nicht mehr rückgeneriert werden können.

Ferner ist es erheblich die Hardwareanforderungen welche durch die im Stand der Technik gegebenen Kodierverfahren gestellt sind in Betracht zu ziehen.

Bei einer solchen Betrachtungsweise kann sich ergeben, daß sich durch bekannte Verfahren, inbesondere durch die bereits dargestellten, zwar eine bzgl. der Verarbeitungszeit akzeptable Lösung ergibt, daß jedoch der Hardwareaufwand erhöht wird. Neben dem Hardwareaufwand generell können auch hierdurch wieder Fehlerquellen induziert werden.

Eine technische Größe zur Bewertung des Hardwareaufwandes zur Realisierung von Kodierverfahren ist die Kodierungstiefe.
Sie gibt an, wieviele Gatterebenen in der physikalischen Realisierung benötigt werden, um den Kode bzw. das Kodierverfahren zu generieren. Im Ergebnis heißt das, daß Kodier- bzw. Fehlererkennungs und- Korrekturverfahren den Hardwareaufwand zuallermeist bedingen. Somit ergibt sich aus den bekannten Verfahren und Einrichtungen immer nur eine Optimierung in der einen oder anderen Weise, d.h. entweder Minimierung der Bearbeitungs- bzw. Rechenzeit, oder Maximierung der Datensicherheit, oder Minimierung des Soft- oder Hardwareaufwandes. Bei bekannten Verfahren werden zumeist immer nur eine der Optimierungen erzielt, die in der Regel auch noch zu Lasten einer anderen geht.

Es ergibt sich in konstruktiver technischer Hinsicht noch ein weiterer Aspekt. Bei dem Bau immer größerer Speicher ergibt sich gleichzeitig die Maßgabe zu immer dichteren Integration, d.h. zu immer kleiner und dichter werdenden Bauelementstrukturen. Das bringt den Nachteil mit sich, daß die Speicherbauelemente bei der Herstellung immer aufwendiger getestet werden müssen, was unter anderem auch zu einer erheblichen Verteuerung des Bauelementes führt. Das heißt, daß in vielen Fällen große Speicherbauelemente (>4Mbit) bei der Herstellung nicht mehr auf 100% Fehlerfreiheit geprüft werden können.

Für die Praxis der Anwender und Verwerter solcher Speicherbauelemente heißt das jedoch, daß die Anforderungen an die Fehlerprüfung beim Datentransfer extrem an Bedeutung gewinnt.

Aus dem Fachbuch "Error-Control-Coding for Computer Systems", T.R.N. Rao, E. Fujiwara; Prentice Hall, Englewood Cliffs, New Jersey 07632 aus dem Jahr 1989, sind eine Reihe von Verfahren bekannt, die zwar der Anforderung hoher Datensicherheit entsprechen, die jedoch aufgrund ihrer mathematischen Komplexität einen erheblichen Soft- und Hardwareaufwand fordern.

Zudem ist bei bekannten Verfahren die Unterscheidung zwischen Fehlern im Datenwort und Fehlern im Prüfwort nicht, oder nicht ausreichend gegeben. Da das Datenwort in der Regel gemeinsam mit dem Prüfwort als Gesamtdatenwort übertragen wird, ist eine fehlende Unterscheidbarkeit hier von großem Nachteil, da die Fehlerqualifizierung ungenau wird.

Ausgehend von dem bekannten Stand der Technik liegt der Erfindung daher die Aufgabe zugrunde ein Verfahren sowie eine Einrichtung der gattungsgemäßen Art derart zu gestalten, daß bei Optimierung der Fehlererkennung und teilweise Fehlerkorrekturmöglichkeiten gleichzeitig die Kodierungstiefe und damit die Zahl der nötigen Gatterebenen minimiert werden kann.

Die gestellte Aufgabe wird hinsichtlich eines Verfahrens der gattungsgemäßen Art erfindungsgemäß durch die kennzeichnenden Merkmale des Patentanspruches 1 gelöst. Weitere verfahrensbezogene vorteilhafte Ausgestaltungen sind in den Unteransprüchen 2 bis 4 angegeben.

Hinsichtlich einer Einrichtung gemäß Oberbegriff des Patentanspruches 5 wird die gestellte Aufgabe erfindungsgemäß durch die kennzeichnenden Merkmale des Patentanspruches 5 gelöst. Weitere einrichtungsbezogene vorteilhafte Ausgestaltungen sind in den übrigen Unteransprüchen angegeben.

Das erfindungsgemäße Verfahren trägt zur Optimierung der Fehlererkennung unter gleichzeitiger Maßgabe die Kodierungstiefe d.h.die nötigen Gatterebenen zu minimieren in einer überraschend einfachen Weise bei. Im Gegensatz zu bekannten Verfahren läßt sich hierbei der Rechenaufwand derartig reduzieren, daß dadurch das Verfahren und damit der gewünschte Datentransfer extrem sicher und zudem noch schneller ist. Dies ist unter anderem dadurch bewirkt, daß die Prüfwortgenerierung vollständig schaltungstechnisch d.h. durch die Hardware also ohne Zuhilfenahme von softwaregenerierten Rechenoperationen erfolgen kann.

Zur Klassifierung der Bedeutung eines Fehlers ist in besonders vorteilhafter Ausgestaltung des Verfahrens vorgesehen, daß Fehler in den Datenbits von Fehlern in den Prüfbits durch die Bestimmung des Gewichtes des Differenzprüfwortes -Syndromwort- unterscheidbar sind.

Besonders vorteilhaft erweist sich die Gestaltung einer Gesamtwortlänge von w=140 Bit, die in eine Datenwortlänge von d=128 Bit und in eine Prüfwortlänge von p=12 Bit unterteilt ist. Die Anzahl der Datenteilworte ist bei einer Datenteilwortlänge von jeweils 4 Bit dann 32. Die Anzahl der Prüfteilworte ist 3, wobei jedes Prüfteilwort aus jeweils 4 Bit besteht. Die Generierung des Prüfwortes für ein Datenwort erfolgt dann aus einer 128* 12 Generatormatrix. Die Prüfwortgenerierung bezüglich des Datenwortes erfolgt dann nach der Maßgabe, daß bei der spaltenweisen Paritätsprüfung jeweils nur 32 Datenbits zur Generierung jeweils 1 Prüfbits berücksichtigt bzw. herangezogen werden. D.h. mit anderen Worten, daß aus jeder der 12 Spalten der 128* 12 Generatormatrix nur aus jeweils 32 Datenbits die Quersumme gebildet wird, woraus dann jeweils eines von zwölf Prüfbits gebildet wird. Dies ist mit der Bezeichnung Generierungsgewicht Gs" gemeint. Gleichzeitig erfolgt die gesammte Präfwortbildung unter der Bedingung, daß die spaltenweise Auswahl der aus 128 Datenbits jeweils berücksichtigten 32 Datenbits derart verteilt sind, daß das Generierungsgewicht Gz jedes Zeilenvektors der Datenbits 3 ist. D.h. dann mit anderen Worten, daß jedes der in diesem Ausgestaltungsbeispiel gegebenen 128 Datenbits jeweils 3 Prüfbits beeinflußt. Die Überprüfung bzw. Sicherung des Prüfwortes selbst weicht von dieser Prüfbitgenerierung bzgl. der Datenbits ab, in einer Weise, die weiter unten noch näher beschrieben ist.

Dadurch ist die Prüfwortgenerierung aus den Datenbits uneinheitlich zur Prüfwortgenerierung aus den Prüfbits.

Bezüglich der erfindungsgemäß vorgeschriebenen Einrichtung ergibt sich insbesondere in Anwendung des erfindungsgemäßen Verfahrens daraus der Vorteil, daß hiermit Datenwortfehler und Fehler im Prüfwort voneinander unterscheidbar sind. Die Fehlerqualifizierung ist damit erheblich verbessert.
Die Forderung der Minimierung der Kodierstiefe ist durch die erfindungsgemäße Einrichtung erfüllt. Durch die so bewirkte Reduzierung der physikalisch notwendigen Gatterebenen ist die Einrichtung bei hoher Fehlerqualifizierungsqualität zudem noch sehr schnell.

Durch die entsprechende Einbringung der Syndrombewertungseinheit ist bewirkt, daß ungültige Prüfworte herausgefiltert werden, und das korrigierte Wort nur dann Verwendung findet, wenn ein korrigierbarer Fehler festgestellt wurde. Dies trägt außerdem zur weiteren Vereinfachung der Einrichtung bei. Die Vereinfachung der gesamten Einrichtung in Anwendung des Verfahrens ist durch die Tatsache gegeben, daß zur letztendlichen Fehlerbewertung bzw. Lokalisierung die Korrektureinheit pro Datenbit nur noch 3 Bits berücksichtigen muß. Diese 3 Bits entsprechen dem durch die Generatormatrix zeilenweise vorgegebenen Generierungsgewicht von 3.

Die Erfindung ist hinsichtlich des Verfahrens sowie der Einrichtung anhand der Zeichnungen ersichtlich, und im nachfolgenden noch näher erläutert.
Es zeigt:
- Fig. 1a: Generatormatrixausschnitt für die Datenbits 0-63, zur Darstellung der verfahrensgemäßen Bedindungen.
- Fig. 1b: Generatormatrixausschnitt in Fortsetzung zu Fig. 1a für die Datenbits 64-127.
- Fig. 1c: Generatormatrix für die 128-139 Bit zur Generierung des Prüfwortüberwachenden Prüfwortbeeinflussung.
- Fig.2: Exklusiv-Oder-Baum für einen Spaltenvektor des 12 Bit-Prüfwortes.
- Fig.3: Verschaltung von 12 Exklusiv-Oder-Bäumen als Prüfwortgenerator bzw. -checker.
- Fig 4: Aufbau der Korrektureinheit.
- Fig.5: Verschaltung und Datenfluß zwischen Generator und Checker.
- Fig.6: Datenfluß über die Korrektureinheit.

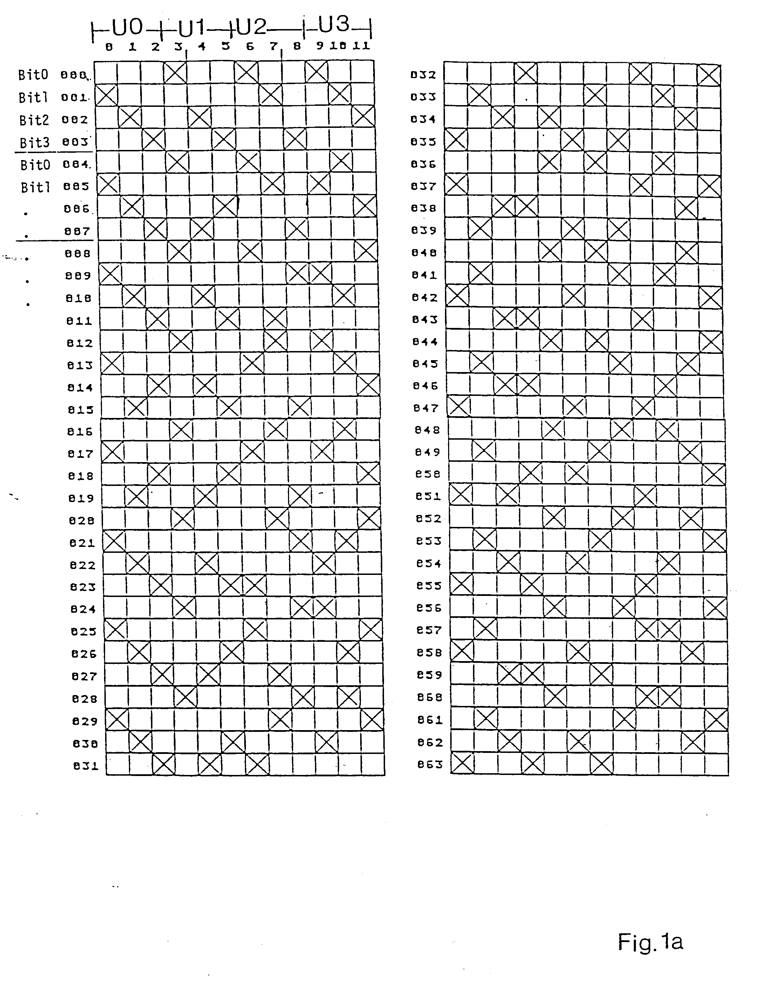

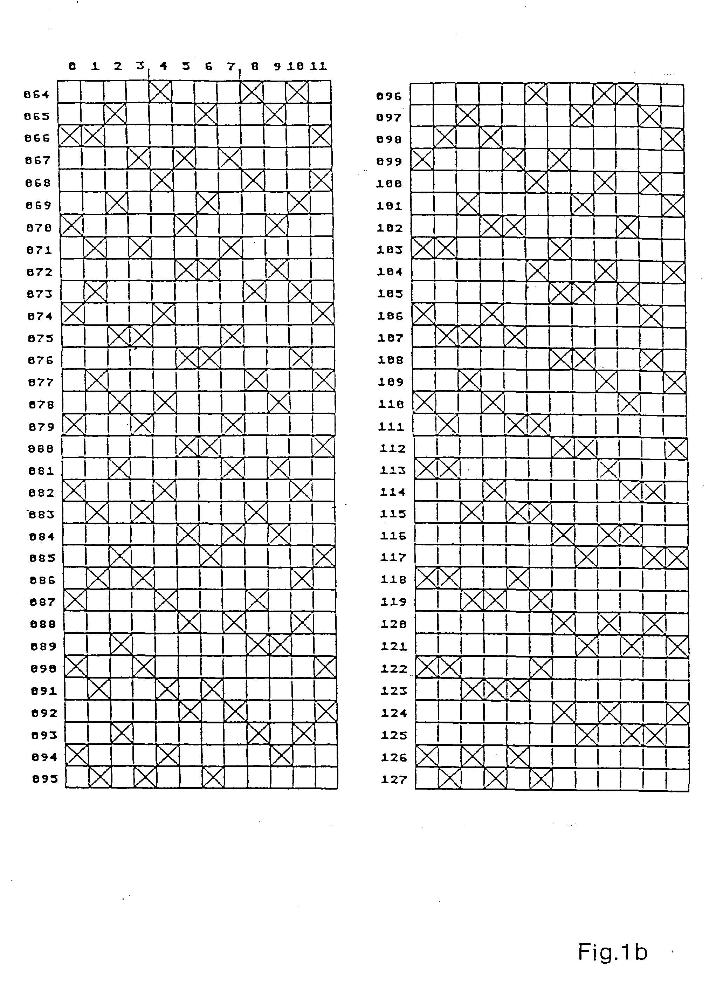

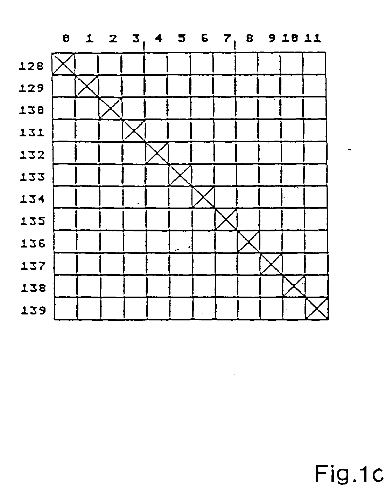

Fig. 1a - 1b zeigt die Generatormatrix, aus der die erfindungsgemäße Verfahrensweise ersichtlich ist. Die Generatormatrix des Prüfwortes bzgl. der Datenwortüberprüfung ist auf die Figuren 1a-1b verteilt, und die einzelnen Matrixblöcke sind mit fortlaufender Bit-nummer des Datenwortes aneinanderzureihen. Anzureihen wäre dann noch die Prüfwort-Matrix gemäß Fig. 1c. Die Senkrechte dieser Matrix gibt die 128 Datenbits vor und die Waagerechte die 12 Bits des Prüfwortes.

Die mit Kreuz versehenen Felder geben an, welche der 128 Datenbits jeweils ein Prüfbit beeinflussen. Dabei gilt die Vorgabe, daß jeweils 1 Prüfbit 32 Datenbits berücksichtigt.
Die 128 Datenbits sind dabei immer zu einem Datenteilwort von 4 Bits zusammengefaßt. Dies ergibt sich zwecksmäßigerweise aus der Tatsache den Speicher aus 32 bzw. 35 (mit Prüfwort) parallelen 4 Bit breiten DRAMs zu implementieren.
Die 12 Prüfbits, die gemäß Fig. 1c den 128 Datenbits angehängt sind, sind in 3 Prüfteilworte zu ebenfalls 4 Bit unterteilt, da sie ebenfalls 4 Bit breiten Speichern zugeordnet werden.
Die Vorgabe des Generierungsgewichtes Gz=3 einer jeden Zeile der Matrix ist an die zusätzliche Bedingung geknüpft, daß jedes Datenbit zeilenweise maximal 2 Bit in einem Prüfteilwort beeinflußt. Letztlich heißt das, daß pro Datenbit (d.h.zeilenweise)nunmehr nur noch 3, anstatt alle 12 Prüfbits, berücksichtigt werden müssen.

Dies macht die Fehlerkorrektur im Falle korrigierbarer Fehler sehr schnell.Das Prüfwort selbst wird entsprechend Fig. 1c kodiert. D.h. bei diesen Fehlererkennung- und Korrekturverfahren handelt es sich um ein Verfahren, daß das Prüfwort nicht in die Generatormatrix mit einbezieht, wie es z.B. bei den in der Literatur verzeichneten Verfahren üblich ist.
Dadurch resultiert eine Asymmetrie im Gewicht Gsy des Syndromwortes bei korrigierbaren Einzelbitfehlern im Datenwort (Gsy=n, n>2) und korrigierbaren Einzelbitfehlern im Prüfwort (Gsy=1). Die Bedingung, daß die Bits innerhalb einer Zeile der Matrix derart verteilt sind, daß maximal 2 Bit in einem der Speicherelementbreite entsprechenden Teilwort kodiert (Kreuz in der Matrix) sind, stellt sicher, das 3-Bit und 4-Bit Fehler innerhalb eines Prüfteilwortes von einem korrigierbaren Dateneinzelbitfehler unterschieden werden können. Dies ermöglicht es, die Korrektureinheit signifikant zu vereinfachen, da nur noch die Kreuze in der Matrix auskodiert werden müssen. Das Vorliegen eines korrigierbaren Datenbitfehlers kann am Gewicht (Quersumme) des Syndromwortes (Differenz zwischen Soll- und Istprüfwort) festgestellt werden. In dem Fall, daß kein Fehler vorliegt, wird das Originaldatenwort übertragen. In dem Fall, daß das Gewicht des Syndromwortes einen korrigierbaren Fehler signalisiert, sind zwei Fälle zu unterscheiden, der korrigierbare Datenbitfehler und der 3-Bit Teilwortfehler im Prüfwort selbst. Im Falle des Datenbitfehlers entspricht das Syndromwort einem entsprechend der Generatormatrix in der Korrektureinheit kodierten Kode, so daß der Korrektureingang für das fehlerhafte Datenbit gesetzt ist und das fehlerhafte Bit korrigiert (invertiert) wird. Im Falle des 3-Bit Teilwortfehlers im Prüfwort stimmt das Syndromwort mit keiner der kodierten Teilen der Generatormatix überein, so daß keiner der Korrektureingänge gesetzt ist. Dadurch entspricht des Datenwort am Ausgang, wie gewünscht dem Originaldatenwort.

Die unübliche Asymmetrie erlaubt also eine erhebliche Verringerung der Kodierungstiefe in der Korrekturlogik, die einen verringerten Hardwareaufwand und damit geringere Realisierungskosten, sowie eine verringerte Korrekturzeit und damit eine höhere Geschwindigkeit zur Folge hat. In diesen beiden Vorteilen liegt der wirtschaftliche Nutzen der Erfindung.

Zur weiteren Erläuterung der Wirkungsweise des erfindungsgemäßen Verfahrens sei hier zunächst der Begriff der Hammingdistanz benutzt. Der Wert der Hammingdistanz gibt an, um wieviele Bits sich ein erstes Prüfwort von einem anderen Prüfwort unterscheidet.

Beim erfindungsgemäß vorgegebenen Verfahren ergibt sich die Fehlerqualifizierung aus dieser Hammingdistanz.

Es ergibt sich daß beliebige 1-Bit Fehler erkannt und korrigiert werden können, daß beliebige 2-Bit Fehler erkannt werden können, und daß außerdem 3-Bit und 4-Bit Fehler insofern sie in einem 4-Bit Datenteilwort auftreten erkannt werden können. Der Speicher ist ja wie oben bereits erwähnt, aus 4-Bit breiten DRAMs aufgebaut. In Verbindung damit erweist sich das erfindungsgemäße Verfahren bezüglich der darin gegebenen Strukturierung der Prüfwortgenerierung als äußerst zweckmäßig.
Bei dieser Strukturierung ergibt sich nämlich erst die Möglichkeit der Erkennung von 3-Bit und 4-Bit Fehlern der oben benannten Art - das heißt innerhalb eines 4-Bit breiten Datenteilwortes auftretend-.
Würde die Datenwortaufteilung und die darauf aufgebaute Prüfwortgenerierung nicht in der erfindungsgemäß dargestellten Weise erfolgen, so wäre die Erkennung dieser speziellen Fehler nicht mit derart geringem Aufwand möglich. Aus dem Stand der Technik sind zwar sogenannte "single byte" - Fehler auch mit speziellen Verfahren detektierbar, jedoch sind diese bekannten Verfahren weitaus komplizierter und aufwendiger, und somit fehleranfällig im Betrieb. Solche single-byte Fehler sind von besonderer Bedeutung, weil diese hierbei - bei der Verwendung 4-Bit breiter Speicherelemente - im Falle eines Hardware-Fehlers anzeigen, daß ein im Speicher verwendetes Speicherbauelement defekt ist. Von daher ergibt sich aus der Tatsache daß das erfindungsgemäß vorgegebene Verfahren hier eine technisch überraschend einfache Betriebsweise vorgibt, daß die Erkennung der oben benannten spezifischen Fehler störungsfrei, schnell und zuverlässig möglich ist. Zur genauen Qualifizierung sind in besonderer Ausgestaltung des erfindungsgemäßen Verfahrens die 12 Bits des Prüfwortes im Hinblick auf die dargestellte Generatormatrix weiter systematisiert, indem die 12 Prüfbits in 4 Untergruppen U0, U1, U2, U3 zu je 3 Bit unterteilt sind und gemäß Anspruch 4 entsprechend systematisiert berücksichtigt werden. Dies ermöglicht die Erkennung und Unterscheidung verschiedener Fehlertypen.

Diese Unterscheidung der einzelnen Fehlertypen ist wie folgt gegeben:
- 1-Bit Fehler in den Datenbits sind durch eine Hammingdistanz von 3 in den Prüfbits, verteilt auf zwei oder drei Prüfteilworte und verteilt auf zwei oder drei Untergruppen erkennbar.
- 1-Bit Prüfwort-Fehler sind durch eine Hammingdistanz von 1 in den Prüfbits gekennzeichnet bzw. erkennbar.
- 2-Bit Fehler ausschließlich in den Prüfbits sind durch eine Hammingdistanz von 2 in den Prüfbits gekennzeichnet.
- 3-Bit und 4-Bit Fehler in den Datenbits resultieren in einer Hammingdistanz von größer oder gleich 4 in den Prüfbits.
- 3-Bit Gruppenfehler in den Prüfbits resultieren in einer Hammingdistanz von 3 in den Prüfbits, wobei nur ein Prüfteilwort betroffen ist, und maximal zwei Untergruppen betroffen sind. Die Prüfworte für diese Fehler kollidieren dadurch nicht mit den Prüfworten für 1-Bit Fehler in den Datenbits.
- 4-Bit Fehler in den Prüfbits ergeben eine Hammigdistanz von 4 in den Prüfbits.
- 3-Bit und 4-Bit Gruppenfehler werden ebenso wie beliebige 2-Bit Fehler erkannt, sind aber von diesen nicht unbedingt unterscheidbar. Dies ist auf Grund der geringen Häufigkeit auch vertretbar.

Desweiteren gilt noch: Jedes Datenbit beeinflusst genau 3 Prüfbits, die derart verteilt sind, daß eine oder zwei der Prüfwort-Untergruppen nicht betroffen sind. Ferner sind die Kodes, d.h. die Prüfbitbeeinflussungen derart verteilt, daß für die Kodierung der Bits eines 4-Bit-Datenteilwortes jedes Prüfbit genau einmal betroffen ist.

Die Verwendung der sogenannten 3-aus-12- Kodierung bzw. - Generierung resultiert in 384 ( 128 * 3 ) Signalen zu kodierenden Signalen. Jedes der 12 Prüfbits wird von genau 32 (384/12) Datenbits beeinflußt. Damit ist die maximale Kodierungstiefe minimiert und es ergibt sich die vorteilhafte Modularität, die die Hardwarerealisierung vereinfacht und eine optimale Verarbeitungsgeschwindigkeit vorgibt. Alle diese Bedingungen sind in der Generatormatrix gemäß Fig. 1a-1c berücksichtigt.

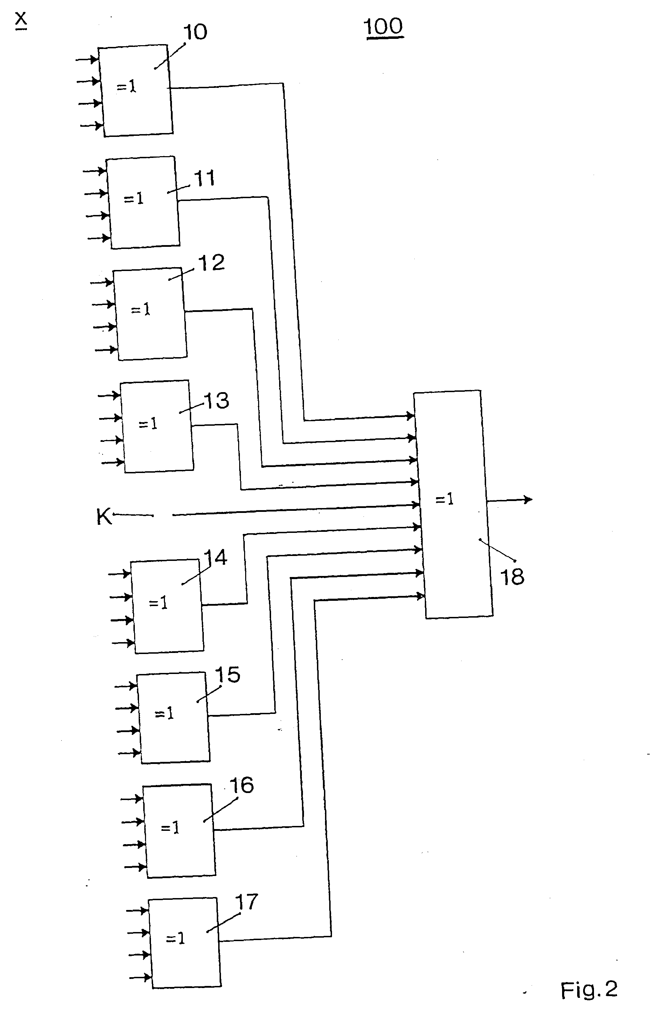

Fig.2 zeigt das hardware-realisierte Grundelement zur Erzeugung des als Ausgestaltungsbeispiel angegeben 12-Bit Prüfwortes aus dem 128-Bit Datenwort. Bereits hier findet die "konstruktive Umsetzung" der Prüfwort-Generatormatrix statt. Die 32 spaltenweise gemäß Generatormatrix zu berücksichtigenden Bits des Datenwortes werden in den hier dargestellten "Exklusiv-Oder-Baum" eingespeist; 32 Eingänge bezeichnet mit X. Hier dargestellt sind jeweils vier Datenbits in ein Exklusiv-Oder-Glied 10, 11, 12,.... eingespeist. Am Ausgang der EX-OR-Glieder wird das Ausgangssignal gemeinsam mit den übrigen Ausgangssignalen der nachfolgenden EX-OR-Stufe 18 zugeführt. Insgesamt wird in dieser dargestellten Stufe die Parität über die ausgesuchten, also eingespeisten 32 Bits einer der 12 Spalten der Generatomatrix gebildet. Zusätzlich wird der EX-OR-Stufe noch ein Kontrollbit K zugeführt, die Funktion dieses Kontrollbits wird weiter unten noch beschrieben. Da die Generatormatrix entsprechend des gewählten 12-Bit breiten Prüfwortes 12 solcher spaltenbezogener Paritätsprüfungen enthält, besteht die Hardware auch aus 12 solcher Exklusiv-Oder-Bäumen. Der Ausgang des EX-OR-Baumes führt dann jeweils eines der 12 Bits des Prüfwortes.

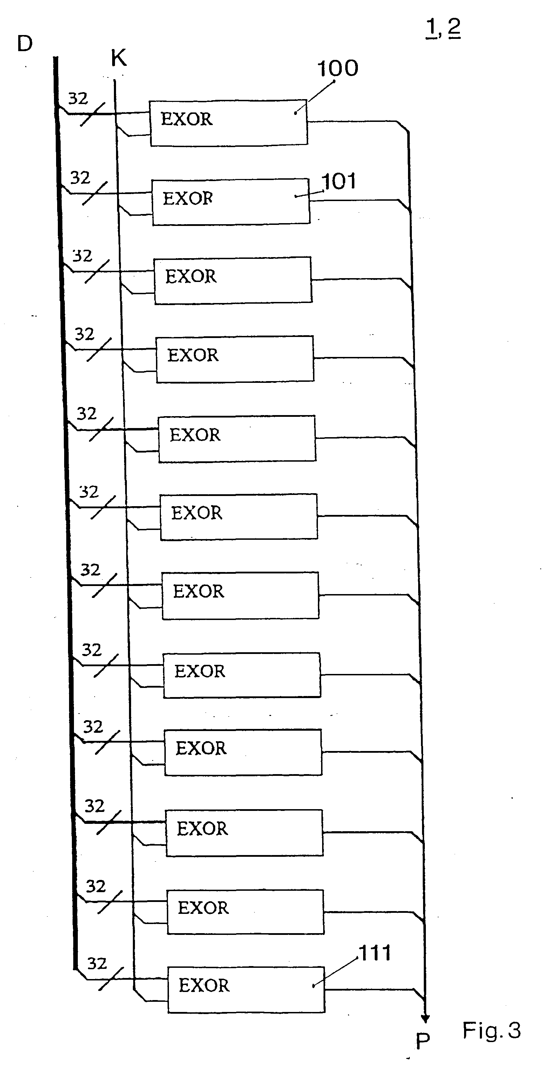

Fig.3 zeigt den gesamten Aufbau des Generators, der aus 12 Anordnungen gemäß Fig.2 zusammengestellt ist. Über die Sammelleitung D wird das 128-Bit Datenwort übertragen. Dieses wird entsprechend der angelegten Generatormatrix d. h. mit der entsprechenden Zuordnung in die jeweils 32 Eingänge der 12 Exklusiv-Oder-Bäume 100, 101 eingespeist. Gemäß Fig.2 ist in jedem Exklusiv-Oder-Baum ein Kontrollbit K einspeisbar, welche dann insgesamt einen 12-Bit Kontrollvektor ergeben.

Die Ausgänge der 12 Exklusiv-Oder-Bäume ergeben dann das gesamte Prüfwort für ein gesamtes Datenwort. Die gesammte Anordnung gemäß Fig.3 ist in der Einrichtung genau zweimal vorhanden, nämlich als Generator 1 und als Prüfer -fortan Checker 2 genannt. Der Aufbau von Generator 1 und Checker 2 ist identisch.

Der oben beschriebene Kontrolleingang K auf der Eingangsseite der Exklusiv-Oder-Bäume 100, 101,.... wird beim Generator 1 im Normalfall jeweils auf den Wert 0 gesetzt. Zu Testzwecken kann dieser Kontrolleingang auf den Wert 1 gesetzt werden, um einen Fehler zu simulieren, und um so die Hardware zu testen.
Beim Checker 2 hingegen werden diese Kontrolleingänge jeweils mit dem entsprechenden empfangenen Prüfbit gespeist, so daß am Ausgang direkt das Fehlersyndrom, d.h. die bitweise Differenz zwischen regeneriertem Prüfwort und empfangenem Prüfwort bereitsteht.

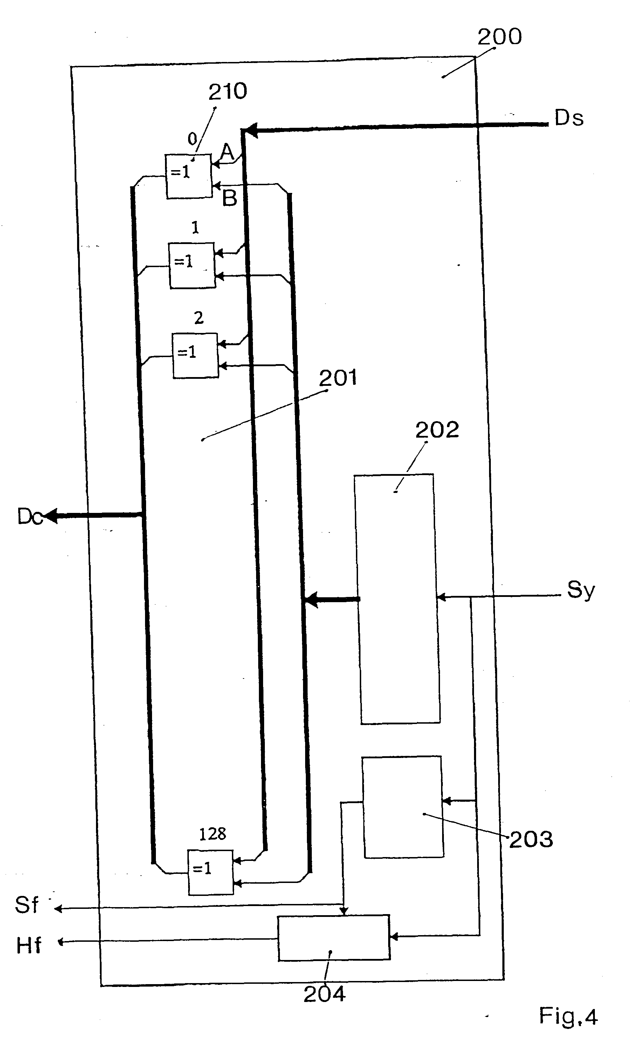

Fig4 zeigt die Korrektureinheit 200 der Einrichtung. Der Korrektureinheit wird das 140 Bit Gesamtdatenwort getrennt in Datenwort Ds und Prüfwort P zugeführt. Das 128 Bit Datenwort wird in die eigentliche Korrekturstufe 201 eingebracht, wo jedes Bit über einen separaten steuerbaren Invertierer 210 läuft, der aus einem einfachen Ex-Or Glied mit zwei Eingängen und einem Ausgang besteht.

Jedes der 128 Bits belegt jeweils einen Eingang A eines Invertierers 210. Der jeweilige andere Eingang B wird über einen Prüfwortmatrixdecoder 202 angesteuert. Der Prüfwortmatrixdecoder 202 wird eingangsseitig vom Differenzprüfwort Sy-Syndromgespeist. Generell sei an dieser Stelle nochmals betont, daß die Fehlerkorrektur natürlich nur in dem Falle eingeleitet wird, in dem ein korrierbarer Fehler erkannt wird. Über den Prüfwortmatrixdecoder 202 wird also die Adresse des entsprechenden fehlerhaften Datenbits aus dem Syndrom Sy-Prüfwort- ermittelt und dann der entsprechende Invertierer 210 angesteuert.
Am Ausgang der Korrektureinheit liegt dann das korrigierte 128-Bit Datenwort Dc vor. Ob, wie oben erwähnt ein korrigierbarer Fehler vorliegt wird in der Syndrombewertungsstufe 203 festgestellt. Hierzu wird das Prüfwort Sy parallel zur Speisung des Prüfwortimatrixdecoders 202 auch der Syndrombewertungsstufe 203 zugeführt.

Der Prüfwortmatrixdecoder 202 dekodiert die Generatormatrix zeilenweise. Ein Bit n des resultierenden 128-Bit Datenwortvektors ist genau dann vom Wert 1, wenn die drei markierten Bit in der entsprechenden Zeile n der Generatormatrix den Wert 1 haben.
Die Einheit wird dadurch vereinfacht, daß ungültige Prüfworte durch die Syndrombewertung herausgefiltert werden und das korrigierte Wort nur dann Verwendung findet, wenn ein korrigierbarer Fehler festgestellt wurde. In diesem Falle wird ein sogenanntes Flag, d. h. ein Daten-Softerror-Flag Sf, von der Syndrombewertung 203 ausgangsseitig gesetzt. Ein Harderror-Flag Hf wird gesetzt, wenn mehr als 1 Bit im Syndrom gesetzt ist und das Softerror-Flag Sf nicht gesetzt ist. Generiert wird das Hard-error-Flag durch den Harderror-Generator 204. Dieser besteht aus einem 12-fach Oder-Gatter, einem Invertierer und einem 2-fach Und-Gatter.

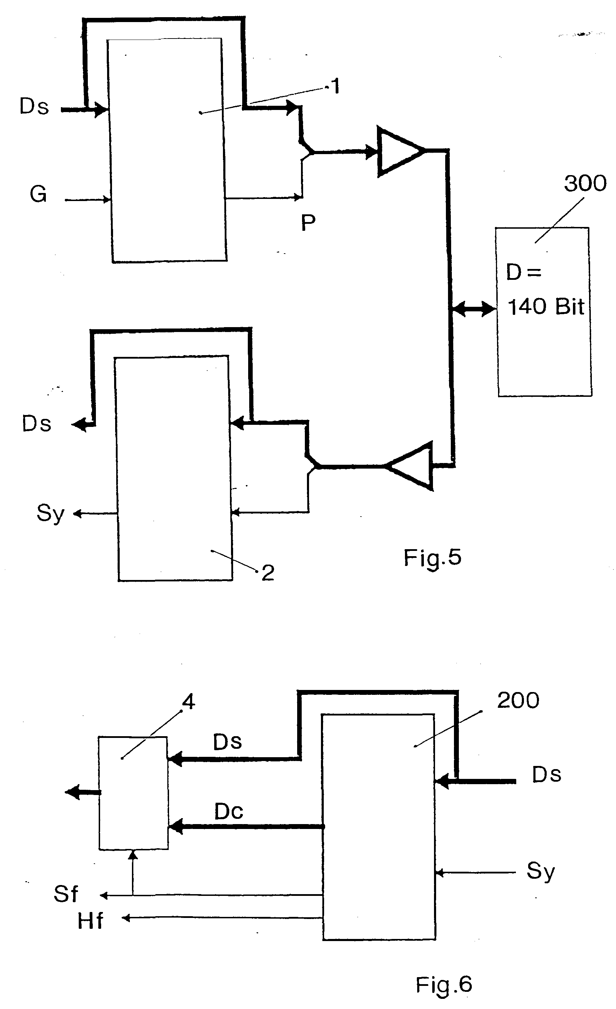

Fig.5 zeigt den Datenfluß zwischen Prüfwort-Generator 1 und Prüfwort-Checker 2, sowie die funktionelle Verknüpfung der einzelnen Elemente. Der Prüfwortgenerator ist beim Datensender plaziert, und liest das 128-Bit Datenwort Ds ein, sowie die 12-Bit Generatormaske G. Das 128-Bit Datenwort wird parallel zum Eingang des Generators 1 auch zum Ausgang des Generators 1 geführt, und dort mit dem 12-Bit Prüfwort P versehen. Insgesamt wird dann ein Gesamtdatenwort D von 140 Bit übertragen. Der Speicherbaustein 300 wird über die mit dem Doppelpfeil markierte Datenleitung bedient. Der Datenfluß erfolgt dabei in beiden Richtungen, d.h. in den Speicher hinein oder heraus. Der Speicherbaustein 300 ist dabei aus 4 Bit breiten DRAMs implementiert, wobei das Datenwort dann in entsprechend 35 DRAMs aufgeteilt ist. Dieses 140 Bit lange Wort ist in voller Länge über das Prüfwort geschützt, da das Prüfwort mitgeschützt ist. Am Empfänger liegt nun dieses Gesamtdatenwort D an, wobei am dort angeordneten Checker 2 getrennt das 128-Bit Datenwort Ds und das Prüfwort P eingespeist wird. Der Checker prüft das Prüfwort und bildet das Differenzprüfwort Sy -Syndrom-.
Das Syndrom wird dann der in Fig.4 beschriebenen Korrektureinheit 200 zugeführt, die nach Fehlerqualifizierung dann gegebenenfalls die Korrektur durchführt.

Der Kontrolleingang gemäß Fig. 2 wird beim Checker 2 gleich mit dem Prüfbit gespeist, sodaß intern die Differenzbildung, also die Syndrombildung vorgenommen werden kann.

Fig. 6 zeigt die der Generator1 /Checker2-Anordnung nachgeschaltete Korrektureinheit 200. Der Ausgang des Checkers 2 aus Fig. 5 liegt am Eingang der Korrektureinheit 200 aus Fig. 6 an. Das Datenwort Ds und das gebildete Syndrom Sy werden in der bereits in Fig. 4 dargestellten Weise eingespeist.
Am Ausgang der Korrektureinheit 200 liegt dann das korrigierte Datenwort Dc an, welches auf einen Eingang des Multiplexers 4 gelegt wird. Parallel dazu wird das unkorrigierte Datenwort Ds auf den anderen Eingang des Multiplexers 4 gelegt. Gemäß der internen Ausbildung der Korrektureinheit 200 wird der Ausgang der Korrektureinheit 200 welcher das Softerror-Flag Sf trägt ebenfalls dem Multiplexer 4 quasi als Steuereingang zugeführt, sodaß der Multiplexer je nach ermitteltem Fehlerstatus entscheiden kann, ob er das korrigierte Datenwort Dc oder das Originaldatenwort Ds am Ausgang führt.
Im Falle eines Harderror-Fehlers wird das entsprechende Harderror-Flag Hf gesetzt und beispielsweise zum Abbruch des Schreib-/Lesevorganges und zur Fehleranzeige weitergeführt.

### Bezugszeichenliste

- U0-U3: Prüfwort-Untergruppen
- D: Datenwort (gesendet d.h. mit Prüfwort)
- Ds: Datenwort (gesendet)
- Dc: Datenwort (korrigiert)
- X: Eingänge der EX-OR-Bäume bzw. -Glieder
- K: Kontrolleingang
- P: Prüfwort
- Sy: Syndromwort
- Sf: Softerror-Flag
- Hf: Harderror-Flag
- A,B: Eingänge der Invertierer
- 1: Generator
- 2: Checker
- 4: Multiplexer
- 10-18: EX-OR-Glieder
- 100-111: EX-OR-Bäume
- 200: Korrektureinheit
- 201: Korrekturstufe
- 202: Prüfwortmatrixdecoder
- 203: Syndrombewerter
- 204: Harderror-Generator
- 210: Invertierer
- 300: Speicherbaustein

## Patentansprüche

1. Verfahren zur Erkennung und/oder Korrektur von 1-Bit und mehr-Bit-Fehlern in Datenworten, welche über Datensammelleitungen in Speicherbausteine hineingeschrieben und aus denselben herausgelesen werden, wobei den Datenworten Prüfworte angehängt werden und durch bitweise Differenzbildung zwischen einem Soll- und einem Ist-Prüfwort nach der Datenübertragung ein Syndromwort erzeugt wird, dessen Wert es ermöglicht im Falle eines Datenfehlers eine Fehlerkorrektur einzuleiten bzw. gegebenfalls eine Wiederholung des Schreib-/Lesevorganges zu veranlassen,
**dadurch gekennzeichnet,**
- daß die Gesamtwortlänge w in eine Datenwortlänge d und in eine Prüfwortlänge p derart unterteilt ist, daß die Bits des Datenwortes in x= d/4 Datenteilworte zu jeweils 4 Bit und die Bits des Prüfwortes in y= p/4 Prüfteilworte zu je 4 Bit gegliedert sind und jedes Teilwort einem 4 Bit breiten Speicherelement zugeordnet wird,
- daß zu einem Datenwort die Generierung des Prüfwortes derart erfolgt, daß unter Verwendung einer d*p Generatormatrix jeder Spaltenvektor (1 bis p) das Generierungsgewicht Gs=d/4 aufweist, so daß bei der spaltenweisen Paritätsbildung jeweils eine Anzahl von d/4 Datenbits ein Prüfbit beeinflusst, und daß gleichzeitig jeder Zeilenvektor das Generierungsgewicht Gz=p/4 aufweist, derart, daß zeilenweise jedes Datenbit maximal 2 Bit in einem Prüfteilwort beeinflusst.

2. Verfahren zur Erkennung und/oder Korrektur von 1- und mehr-Bit-Fehlern in Datenworten, nach Anspruch 1,
**dadurch gekennzeichnet,**
daß die Gesamtwortlänge w= 140 Bit und davon die Datenwortlänge d=128 Bit und die Prüfwortlänge p=12 Bit beträgt, sodaß die Anzahl der Datenteilworte x=32 und die Anzahl der Prüfteilworte y=3 beträgt.

3. Verfahren zur Erkennung und/oder Korrektur von 1- und mehr-Bit-Fehlern nach Anspruch 2,
**dadurch gekennzeichnet,**
daß korrigierbare Einzelbitfehler im Prüfwort sich durch ein Gewicht des Syndromwortes von Gsy=3 von korrigierbaren Einzelbit-Fehlern im Datenwort, welche ein Gewicht des Syndromwortes von Gsy=1 aufweisen, unterscheiden, und daß nach Erkennung eines solchen Fehlers die Fehlerkorrektur durch Invertieren des fehlerhaften Bit veranlaßt wird.

4. Verfahren zur Erkennung und/oder Korrektur von 1- und mehr-Bit-Fehlern nach Anspruch 3,
**dadurch gekennzeichnet,**
daß zur weiteren Fehlerunterscheidung die Generatormatrix bei der Prüfwortgenerierung unter der weiteren Bedingung steht, daß das Prüfwort sich in 4 Untergruppen U0,U1, U2, U3 zu je 3 Bit unterteilen läßt, derart, daß
die 32 Bit 0 der 32 Datenteilworte die Untergruppe U0,
die 32 Bit 1 der 32 Datenteilworte die Untergruppe U1,
die 32 Bit 2 der 32 Datenteilworte- die Untergruppe U2,
die 32 Bit 3 der 32 Datenteilworte die Untergruppe U3
unbeeinflußt lassen.

5. Einrichtung zur Erkennung und/oder Korrektur von 1- und mehr-Bit-Fehlern in Datenworten, welche über Datensammelleitungen in Speicherbausteine hineinschreibbar und aus denselben herauslesbar sind, wobei den Datenworten in Generatoren Prüfworte angehängt werden, und gemeinsam mit dem Datenwort von einem Datensender übertragbar sind und bei einem Datenempfänger aus einer Differenzbildung des Istprüfwortes mit dem Sollprüfwort ein Syndromwort erzeugbar ist, durch welches durch entsprechende Ansteuerung einer Korrektureinheit eine Fehlerkorrektur bzw. eine Wiederholung des Schreib-/Lesevorganges veranlassbar ist,
**dadurch gekennzeichnet,**
daß eine Anzahl p EX-OR-Bäume (100, 101, .....) vorgesehen sind, welche jeweils bezogen auf eine mit Prüfworten versehene Datenwortlänge (d) eine Anzahl von jeweils d/4 Eingängen X aufweisen, welche von d/4 ausgesuchten Bits des Datenwortes gespeist werden, und am jeweiligen Ausgang (18) als Ergebnis jeweils eines von einer Anzahl p Prüfbits vorliegt, sodaß insgesamt durch die Anzahl p EX-OR-Bäume (100,101,...) die gesamten p Prüfbits des Prüfwortes erzeugbar sind,
daß datensenderseitig der Generator (1) dem Datenwort (Ds) das Prüfwort (P) anhängt, und daß empfängerseitig ein dem Generator (1) baugleicher Checker (2) vorliegt, der ausgangsseitig das Syndromwort (Sy) bildet und gemeinsam mit dem Datenwort (Ds) an die Korrektureinheit (200) weitergibt, welche aus einer Anzahl d Invertierern (210) aufgebaut ist, und der eine Eingang (A) jedes Invertierers mit einem von d Datenbits ansteuerbar ist, und der jeweils andere Eingang (B) vom jeweiligen Ausgang eines syndromgespeisten Prüfwortmatrixdecoders (202) ansteuerbar ist, und die Ausgänge der Invertierer zusammengenommen das korrigierte Datenwort ergeben.

6. Einrichtung zur Erkennung und/oder Korrektur von 1- und mehr-Bit-Fehlern in Datenworten nach Anspruch 5,
**dadurch gekennzeichnet,**
daß die EX-OR-Bäume (100, 101,....) derart ausgebildet und mit der Anzahl d/4 Datenbits korrespondierend sind, unter Realisierung einer d*p Generatormatrix bei der jeder Spaltenvektor (1 bis p) das Generierungsgewicht Gs = d/4 aufweist, so daß bei der spaltenweisen Paritätsbildung jeweils eine Anzahl von d/4 Datenbits ein Prüfbit beeinflusst und daß gleichzeitig jeder Zeilenvektor das Generierungsgewicht Gz=p/4 aufweist derart, daß zeilenweise jedes Datenbit maximal 2 Bit in einem aus 4 Bit bestehenden Prüfteilwort beeinflusst.

7. Einrichtung zur Erkennung und/oder Korrektur von 1- und mehr-Bit-Fehlern in Datenworten nach Anspruch 6,
**dadurch gekennzeichnet,**
daß die Korrektureinheit (200) einen Syndrombewerter (203) aufweist, dem parallel zum Prüfwortmatrixdecoder (202) das Syndromwort (Sy) zuführbar ist, und daß über den Syndrombewerter (203) aus dem Gewicht des Prüfwortes ein Softerror-Flag (Sf) oder ein Harderror Flag (Hf) setzbar ist, daß über das Softerror-Flag ein Multiplexer (4) ansteuerbar ist, der aus gesendetem Datenwort (Ds) und korrigiertem Datenwort (Dc) das gültige Datenwort auswählt.

8. Einrichtung zur Erkennung und/oder Korrektur von 1- und mehr-Bit-Fehlern in Datenworten, nach einem oder mehreren der vorhergehenden Ansprüche,
**dadurch gekennzeichnet,**
daß jeder EX-OR-Baum (100, 101,......) mit einem zusätzlichen Kontrolleingang K versehen ist.

9. Einrichtung zur Erkennung und/oder Korrektur von 1- und mehr-Bit-Fehlern in Datenworten, nach Anspruch 8,
**dadurch gekennzeichnet,**
daß beim Checker (2) am jeweiligen Kontrolleingang direkt das entsprechend empfangene Prüfbit einspeisbar ist, so daß am Ausgang des jeweiligen EX-OR-Gliedes (18) das entsprechende Bit des Syndromwortes verfügbar ist.

10. Einrichtung zur Erkennung und/oder Korrektur von 1- und mehr-Bit-Fehlern in Datenworten, nach einem oder mehreren der vorhergehenden Ansprüche,
**dadurch gekennzeichnet,**
daß die Anzahl von Eingängen (X) der EX-OR-Bäume (100, 101,...) so gewählt ist, daß die Datenwortlänge d=128 Bit einspeisbar ist, und die Ausgänge eine Anzahl von 12 Prüfbits ergeben, sodaß die Anzahl der Datenteilworte x=32 zu je 4Bit und die Anzahl der Prüfteilworte y=3 zu je 4 Bit beträgt.
